Europäisches Patentamt

(19) European Patent Office

Office européen des brevets

(11) Numéro de publication : **0 007 005**
**B1**

(12) **FASCICULE DE BREVET EUROPÉEN**

(45) Date de publication du fascicule du brevet :
24.04.85

(21) Numéro de dépôt : 79101844.3

(22) Date de dépôt : 11.06.79

(51) Int. Cl.⁴ : **H 01 L 21/31, H 01 L 21/76**

(54) **Procédé de fabrication de transistors à effet de champ du type métal-oxyde-semiconducteur à grille et trous de contact auto-alignés.**

(30) Priorité : **30.06.78 US 920913**

(43) Date de publication de la demande :
**23.01.80 Bulletin 80/02**

(45) Mention de la délivrance du brevet :
**24.04.85 Bulletin 85/17**

(84) Etats contractants désignés :
**DE FR GB**

(56) Documents cités :
**FR-A- 2 130 397**
**US-A- 3 752 711**
**IBM TECHNICAL DISCLOSURE BULLETIN, Volume 16, no. 5, octobre 1973, New York R.E. CHAPPELOW et al. "Diffusing sources and drains in complementary field-effect transistors"**
**IBM TECHNICAL DISCLOSURE BULLETIN, Volume 19, no. 2, juillet 1976, New York S.A. ABBAS et al. "Double self-registration method"**

(73) Titulaire : **International Business Machines Corporation**
**Old Orchard Road**
**Armonk, N.Y. 10504 (US)**

(72) Inventeur : **Dennard, Robert Heath**
**Croton Lake Road**
**Croton-on-Hudson, N.Y. 10520 (US)**
Inventeur : **Rideout, Vincent Leo**
**3036 Knollwood Court**
**Mohegan Lake, N.Y. 10547 (US)**

(74) Mandataire : **Klein, Daniel Jacques Henri**
**Compagnie IBM France Département de Propriété Industrielle**
**F-06610 La Gaude (FR)**

## Description

Domaine technique

La présente invention concerne un procédé de fabrication de transition à effet de champ du type MOS et plus particulièrement, un procédé de fabrication d'un transistor à effet de champ du type MOS à canal n, à grille et trous de contact auto-alignés.

Etat de la technique antérieure

On sait que des circuits intégrés contenant des dizaines de milliers de transistors peuvent être réalisés sur un unique substrat ou bloc semiconducteur et que des interconnexions électriques doivent être établies entre de tels transistors. Un bloc semiconducteur typique peut avoir 6 mm ou moins de côté. Pour une fonction désirée quelconque que le circuit intégré devra assurer, la surface du bloc est essentiellement déterminée en fonction de la place requise aux fins de l'isolement entre les différents dispositifs qu'il comporte (transistors, condensateurs, résistances), les conducteurs d'interconnexion (silicium diffusé, polysilicium, aluminium) et les régions ou les trous de contact servant à établir des connexions électriques. L'un des éléments d'un circuit intégré classique qui nécessite beaucoup de place est la région où s'effectue le contact entre le métal et une région du substrat diffusée ou implantée.

La référence US-A-3 752 711 (Philips) se rapporte à un procédé de fabrication d'un transistor à effet de champ à porte isolée (IGFET), l'électrode de porte étant auto-alignée par rapport aux régions de source et de drain. Ce transistor est formé dans un caisson isolé par des régions d'oxyde encastré (8). En outre, il est muni d'une région de blocage de canal parasite (9). L'inconvénient de ce procédé réside dans le fait que les contacts avec les régions source et drain sont réalisés de façon classique à travers une couche relativement épaisse (12, 13) de SiO$_2$ et que par conséquent ils ne sont pas auto-alignés avec ces régions. On peut également observer que la couche de barrière d'oxydation (2) est laissée, au seul emplacement de l'électrode de porte et que par conséquent, la portion restante (11) est disposée au centre de la structure.

La référence FR-A-2 134 290 (Texas) concerne la fabrication d'un IGFET, dont, non seulement l'électrode de porte est auto-alignée avec les régions source et drain, mais également les contacts avec ces régions. Cependant, on peut faire deux remarques :

— d'abord, dans cette référence, la couche de barrière d'oxydation (12, 13) est laissée à l'emplacement de la porte du transistor à former et donc au centre de la structure ;

— ensuite ce transistor n'est pas formé dans un caisson isolé, par exemple par des régions d'oxyde encastré et qu'il n'est pas muni de régions de blocage de canal parasite, ces régions sont donc à prévoir en supplément. En d'autres termes, les régions d'oxyde encastrée 18 n'ont pour seul et unique objet, que de permettre l'auto-alignement des électrodes de porte (23) et des contacts de source et de drain (21, 22).

Exposé de l'invention

Un premier objet de la présente invention est de fournir un procédé de fabrication de transistors à effet de champ du type métal-oxyde-semiconducteur à grille et trous de contact auto-alignés qui comportent un nombre d'étapes de fabrication moindre en comparaison avec les procédés connus.

Un autre objet de la présente invention est de fournir un procédé de fabrication de transistors à effet de champ du type métal-oxyde-semiconducteur à grille et trous de contact auto-alignés qui présentent des caractéristiques plus avantageuses (notamment en termes de densit) que les transistors de l'art antérieur.

La présente invention telle que revendiquée, concerne un procédé de fabrication d'un transistor à effet de champ à grille et à trous de contact auto-alignés. Ce procédé est caractérisé en ce qu'il comporte les étapes suivantes :

a) élaboration d'un substrat semiconducteur d'un premier type de conductivité,

b) formation d'une couche de barrière d'oxydation sur le substrat selon une configuration délimitée,

c) oxydation des portions exposées du substrat à travers les ouvertures de la couche de barrière, pour former des premières régions d'isolement encastrées, épaisses qui définissent une pluralité de régions semiconductrices isolées,

d) élimination de la couche de barrière selon une nouvelle configuration délimitée ; de telle sorte que la partie restante de la couche de barrière soit adjacente auxdites premières régions et exposant une portion centrale du substrat,

e) formation d'une nouvelle mince couche d'oxyde de porte sur les parties exposées du substrat,

f) dépôt sur cette mince couche isolante dans sa partie centrale d'une électrode de porte en polysilicium dopé,

g) implantation d'ions d'impuretés d'un type opposé de conductivité dans le substrat pour former les régions source et drain d'un transistor à effet de champ et à porte isolée auto-alignée,

h) oxydation des portions exposées du substrat et de l'électrode de porte pour former les couches d'isolement puis élimination des parties restantes de la couche de barrière d'oxydation qui forme des trous de contact auto-alignés avec les régions de sources et de drain et formation d'un trou de contact pour exposer la porte en polysilicium et,

i) formation d'un réseau d'interconnexion de conducteurs selon une configuration désirée qui fournit les contacts électriques avec les régions source, drain et porte.

D'autres objets, caractéristiques et avantages de la présente invention ressortiront mieux de l'exposé qui suit, fait en référence aux dessins annexés à ce texte, qui représentent un mode de réalisation préféré de celle-ci.

Brève description des figures

Les figures 1 à 5 sont des vues en coupe d'un transistor à effet de champ à porte en polysilicium comportant des trous de contact auto-alignés avec les régions source et drain, réalisé conformément à la présente invention, au cours des différentes étapes de fabrication.

Les figures 6 à 10 sont des vues de dessus des configurations de masquage du transistor à effet de champ des figures 1 à 5 respectivement.

Les figures 11 et 12 sont des vues de dessus de cellules à un seul dispositif pour mémoire à accès aléatoire du type dynamique, la figure 11 représentant des trous de contact précis par décapage conformément aux techniques de l'art antérieur, et la figure 12, des trous de contact auto-alignés réalisés conformément au présent procédé.

Description de l'invention

Dans un but de simplicité, la description des différentes étapes du procédé de fabrication de l'invention est faite ci-après en pré-supposant l'emploi d'un substrat semiconducteur en silicium de type p et d'impuretés diffusées ou implantées de type n. Cela conduit à la technologie des transistors à effet de champ à canal n. Il est sous-entendu qu'un substrat de type n et que des impuretés diffusées ou implantées de type p pourraient être utilisés conformément à la présente invention en utilisant la technologie des transistors à effet de champ à canal p.

Il est également sous-entendu que le présent procédé s'applique à des substrats de type classique autres que des substrats en silicium. Par ailleurs, les termes « lignes d'interconnexion de type métallique » ou « lignes d'interconnexion à conductivité élevée » se rapportent à des lignes constituées par un métal tel que l'aluminium, ou par des matériaux non métalliques (par exemple du polysilicium fortement dopé ou encore des siliciures intermétalliques) qui peuvent présenter des conductivités comparables à celles des métaux conducteurs. Les termes « polysilicium » et « silicium polycristallin », d'une part, et, d'autre part, « oxyde » et « dioxyde de silicium » sont ici synonymes, de même que dans l'art antérieur. Il est enfin sous-entendu que lorsque des références seront faites ci-après à des impuretés d'un « premier type » et à des impuretés d'un « second type », lorsque les impuretés du « premier type » seront des impuretés de type n, les impuretés du « second type » seront du type de conductivité opposé, c'est-à-dire de type p et vice-versa.

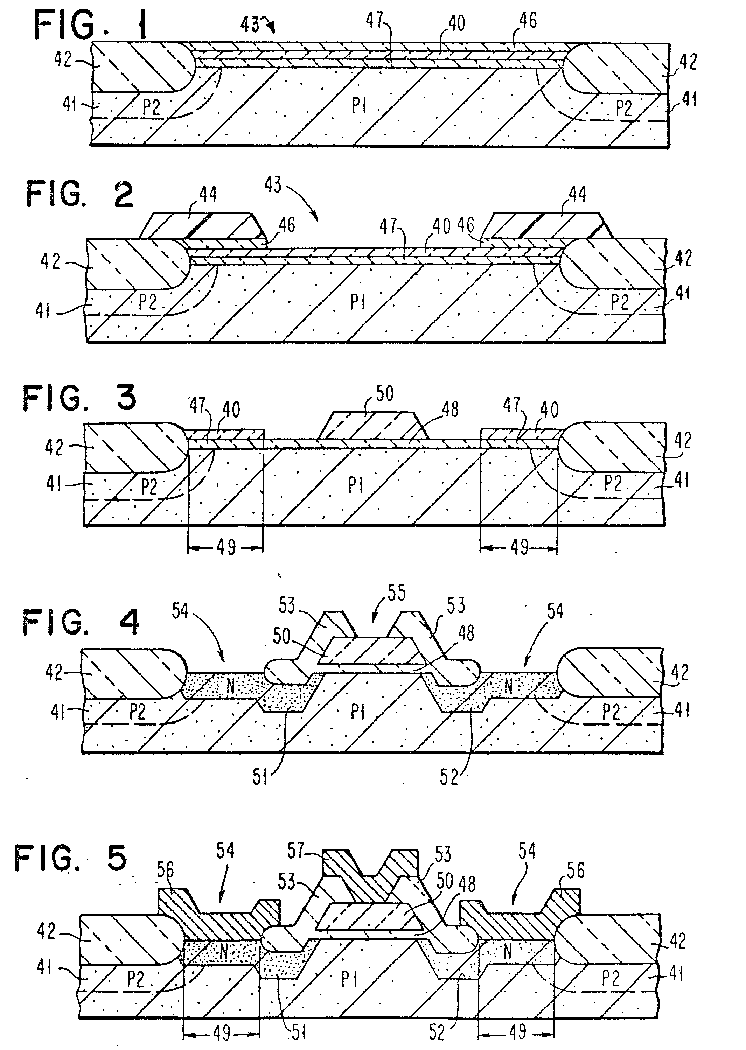

Les figures 1 à 5 représentent des vues en coupe d'un transistor à effet de champ du type métal-oxide-semiconducteur (ci-après appelé MOSFET) à porte en polysilicium en utilisant le procédé de la présente invention dont la grille et les trous de contact sont auto-alignés au cours de sa fabrication.

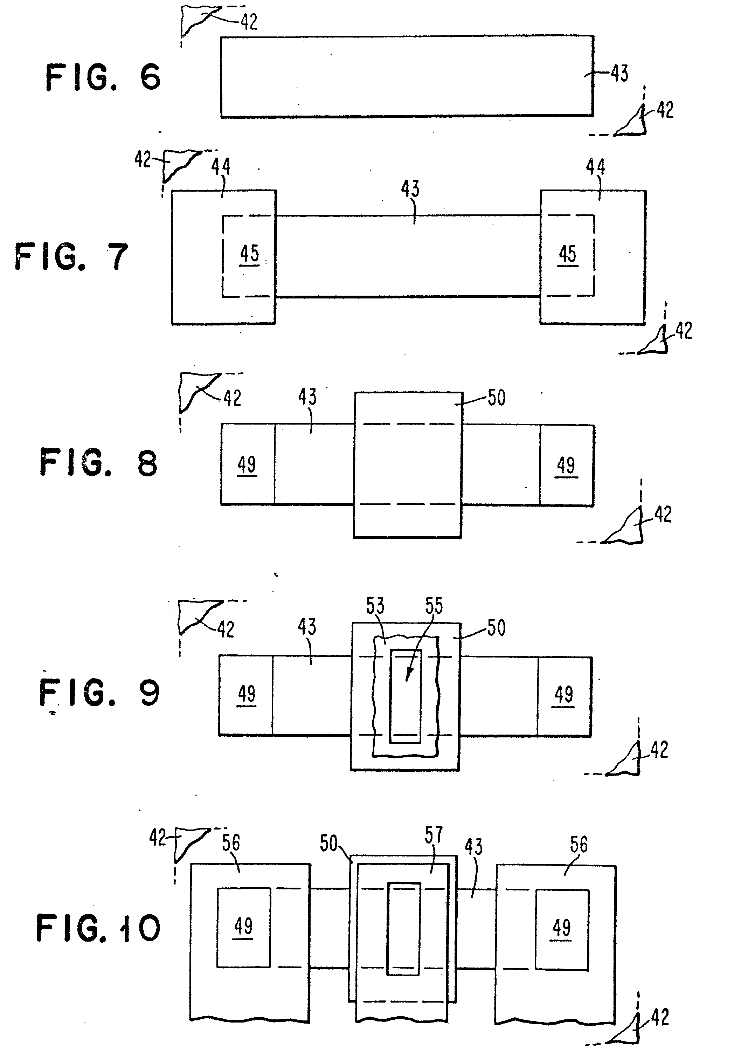

Les figures 6 à 10 sont des vues de dessus mettant en évidence les masques utilisés aux fins de la réalisation du transistor des figures 1 à 5.

Le circuit comprend un substrat en silicium de type p présentant une orientation cristallographique désirée (par exemple ⟨ 100 ⟩ et une concentration de dopage $p_1$ d'une valeur approximative de $1 \times 10^{15}$ cm$^{-3}$. Le substrat est réalisé en découpant et en polissant un barreau de silicium que l'on a fait croître en présence d'un dopant de type p, tel que le bore, au moyen de techniques classiques. D'autres dopants de type p pour le silicium comprennent le gallium et l'indium. Dans le présent procédé, la première opération de masquage lithographique permet de former, de façon connue, des régions d'isolement en oxyde encastrées 42, et des régions 41 associées d'interruption (ou de blocage) de canal de type p présentant une concentration de dopage, $p_2$, d'environ $1 \times 10^{17}$ cm$^{-3}$. Les régions encastrées permettront d'isoler électriquement des parties adjacentes du dispositif, et les régions d'interruption de canal serviront à empêcher la circulation des courants de fuite parasites entre ces parties adjacentes et au-dessous des régions d'isolement.

Pour former une région encastrée d'oxyde, il est nécessaire de délimiter une barrière d'oxydation adhérente, par exemple en nitrure de silicium, en nitrure d'aluminium, en nitrure de bore, en oxyde d'aluminium ou en carbure de silicium, au-dessus des régions dites actives où les dispositifs seront ultérieurement formés. De préférence, cette barrière d'oxydation est en nitrure de silicium d'une épaisseur de 300 à 1 000 Å environ et de préférence de 700 Å. Cette barrière d'oxydation est représentée sous la forme de la couche 40 sur la figure 1. La couche 40 peut être formée en utilisant des techniques classiques de dépôt chimique en phase vapeur. De minces couches supplémentaires de dioxyde de silicium 46 et 47 peuvent être prévues de part et d'autre de la couche 40, comme le montre la figure 1, pour faciliter la définition de la couche 40 d'une part et éviter d'endommager les régions actives sous-jacentes, d'autre part. La couche 47 a une épaisseur d'environ 300 à 1 000 Å, et de préférence de 400 Å, et est formée par dépôt chimique en phase vapeur, ou mieux par oxydation thermique dans de l'oxygène sec à une température comprise entre 900 et 1 000 °C, et de préférence égale à 950 °C. La couche 46 a une épaisseur comprise entre 300 et 1 000 Å environ, et de préférence égale à 500 Å, et est formée elle-aussi par dépôt chimique en phase vapeur.

Sur les figures 1 et 6, la couche composite : couche de nitrure 40 servant de barrière d'oxydation — couches d'oxyde 46, 47 — est délimitée ;

une région d'interruption de canal 41 en bore est implantée, la configuration en résine photo-sensible est dissoute et l'on fait croître la région d'isolement 42 en oxyde. Cette dernière doit être formée par oxydation thermique, de préférence en présence de vapeur d'eau à une température d'environ 950 °C, jusqu'à obtention d'une épaisseur d'environ 6 500 Å. La première opération de masquage est alors terminée ; la région encastrée d'isolement en oxyde 42 a été formée et l'on a délimité une région 43 dans laquelle un transistor à effet de champ sera formé.

Comme on peut le voir sur les figures 2 et 7, la couche d'oxyde 46 a été délimitée selon une configuration désirée. On notera en se reportant à la figure 7 que la couche de masquage en résine 44 est disposée selon une configuration désirée au-dessus de certaines parties ou portions de la région 43 et recouvre partiellement les régions encastrées d'isolement 42 qui se trouvent aux extrémités de la région 43, de manière à permettre un auto-alignement. Comme le montre la figure 7, la couche de masquage 44 se compose de régions rectangulaires recouvrant partiellement ou totalement les régions 42. La seconde opération de masquage est alors terminée. Pour former un contact de dimensions minimum, il est indispensable que la ligne de résine sensible et la ligne dopée (réalisée lors d'une étape ultérieure) dont l'intersection définit le contact aient toutes deux une largeur minimum et s'étendent jusqu'aux régions encastrées 42 qui se trouvent de part et d'autre de la région dopée, donnant ainsi une région de contact rectangulaire 45, comme le montre la figure 7.

La mince couche d'oxyde 46 est décapée dans de l'acide fluorhydrique tamponné, les régions 44 sont alors dissoutes dans un solvant approprié. La couche de nitrure 40 servant de barrière d'oxydation est décapée dans une solution d'acide phosphorique chaud, et finalement les portions exposées des couches d'oxyde 46 et 47 sont éliminées dans de l'acide fluorhydrique tamponné.

Comme le montrent les figures 3 et 8, une mince couche 48 d'oxyde de porte du transistor à effet de champ est formée de nouveau, de préférence par oxydation thermique à 950 °C environ en présence d'oxygène, jusqu'à obtention d'une épaisseur de préférence égale à environ 500 Å. La couche 48 n'est pas formée dans les régions de contact 49 qui sont protégées par les parties restantes de la couche de nitrure 40. Une couche de polysilicium est ensuite déposée, de préférence par dépôt chimique en phase vapeur, et est dopée au moyen d'une impureté de type n en utilisant des techniques classiques d'implantation ou de diffusion. Une couche de résine photosensible est ensuite appliquée sur la structure et l'on obtient après exposition et développement de la résine et décapage des parties exposées de la couche de polysilicium la région en polysilicium 50 représentée sur les figures 3 et 8. La région 50, qui constitue l'électrode de porte du MOSFET peut éventuellement être recouverte d'une mince couche d'oxyde de manière à faciliter sa délimitation. La troisième opération de masquage est alors terminée.

Les régions de source et de drain de type n, respectivement référencées 51 et 52, d'un transistor à effet de champ sont ensuite formées de la façon indiquée, par diffusion ou par implantation ionique, de la façon précédemment décrite. On procédera de préférence à une implantation ionique d'ions d'arsenic en utilisant une énergie d'environ 150 KeV et une dose d'environ $4 \times 10^{15}$ cm$^{-2}$. Une couche d'isolement en oxyde et de passivation 53 est ensuite formée au-dessus des régions 51 et 52 et au-dessus de la région en polysilicium de type n 50 (figure 4). La couche épaisse 53 doit être formée par oxydation thermique, de préférence en présence de vapeur d'eau à 900 °C environ, jusqu'à obtention d'une épaisseur de 5 000 Å environ. La couche 53 s'étend jusqu'à la limite des parties restantes de la couche 40 servant de barrière d'oxydation de telle sorte que ces parties restantes soient entourées d'oxyde d'isolement et forment des trous de contact auto-alignés 54. Les parties restantes de la couche de nitrure 40 sont ensuite retirées par dissolution dans de l'acide phosphorique chaud. Il n'y a pas lieu de procéder alors à un masquage de la structure car le solvant employé pour dissoudre le nitrure n'attaque pas les autres parties de la structure qui sont recouvertes de dioxyde de silicium. Une couche de masquage présentant la configuration représentée sur la figure 9 est ensuite utilisée.

Un trou de contact 55 donnant accès à la région de polysilicium 50 est formé par décapage chimique ou effectué dans du plasma, de façon classique. Un dopant supplémentaire de type n peut éventuellement être utilisé dans les régions de contact par implantation générale d'ions de phosphore. L'ensemble de la structure est ensuite soumis à une étape de décapage par trempage qui retire les parties restantes de la mince couche d'oxyde 47 dans les régions de contact 49. Cette étape n'affecte pas de façon importante l'épaisseur des couches 42 et 53. La figure 4 représente une coupe de la structure qui est alors obtenue.

Une couche d'aluminium est ensuite déposée sur la structure et délimitée au moyen d'une cinquième couche de masquage en résine. Cette étape de lithographie permet d'obtenir des contacts 56 avec les régions de contact 49 et un contact 57 avec la porte en polysilicium 50. Des couches métalliques intermédiaires peuvent être prévues pour éviter une pénétration métallique et améliorer la fiabilité des contacts, de la façon précédemment décrite. Une coupe du transistor à effet de champ qui est obtenu à la fin de ce processus est représentée sur la figure 5. La vue de dessus correspondante est la figure 10. Enfin, des opérations classiques de passivation, de découpe et de liaison par fils ou bille de soudure (non représentées) sont effectuées pour achever la fabrication du circuit intégré. Le processus de fabrication de transistor MOSFET décrit ci-dessus exige cinq opérations de masquage afférentes aux délimitations des régions encastrées d'oxyde d'isolement (M1), des trous de contact auto-alignés (M2), de la porte en polysilicium (M3), des trous de contact décapés donnant accès aux régions en polysilicium (M4), et de la configuration d'interconnexion en aluminium (M5).

Application industrielle de l'invention

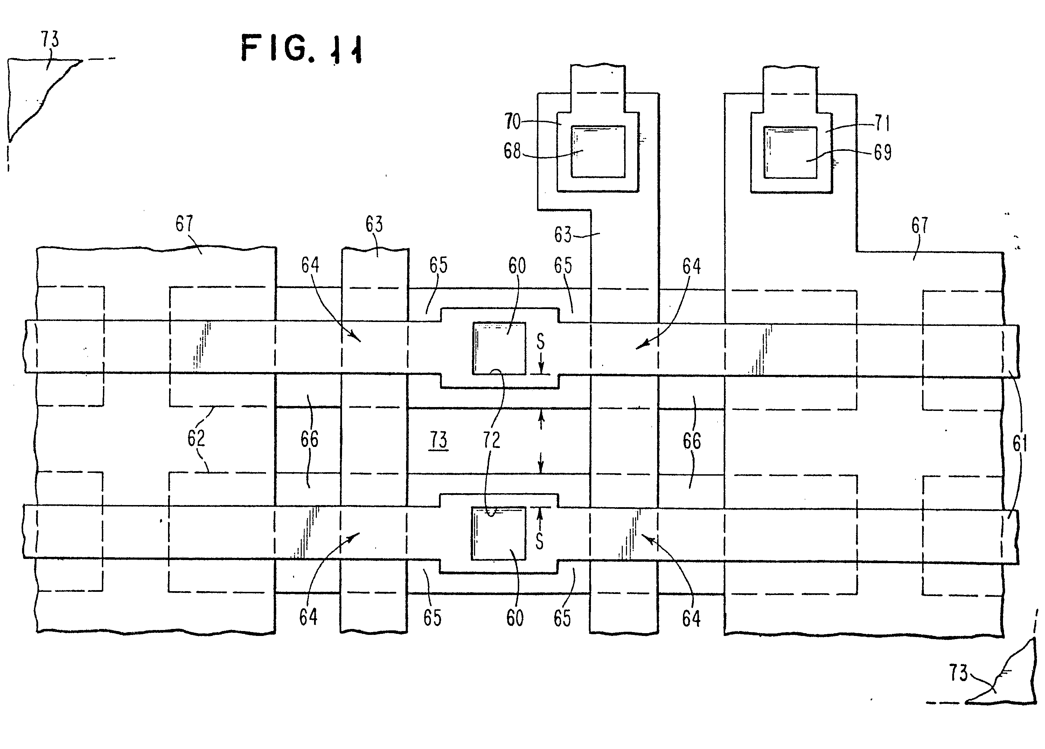

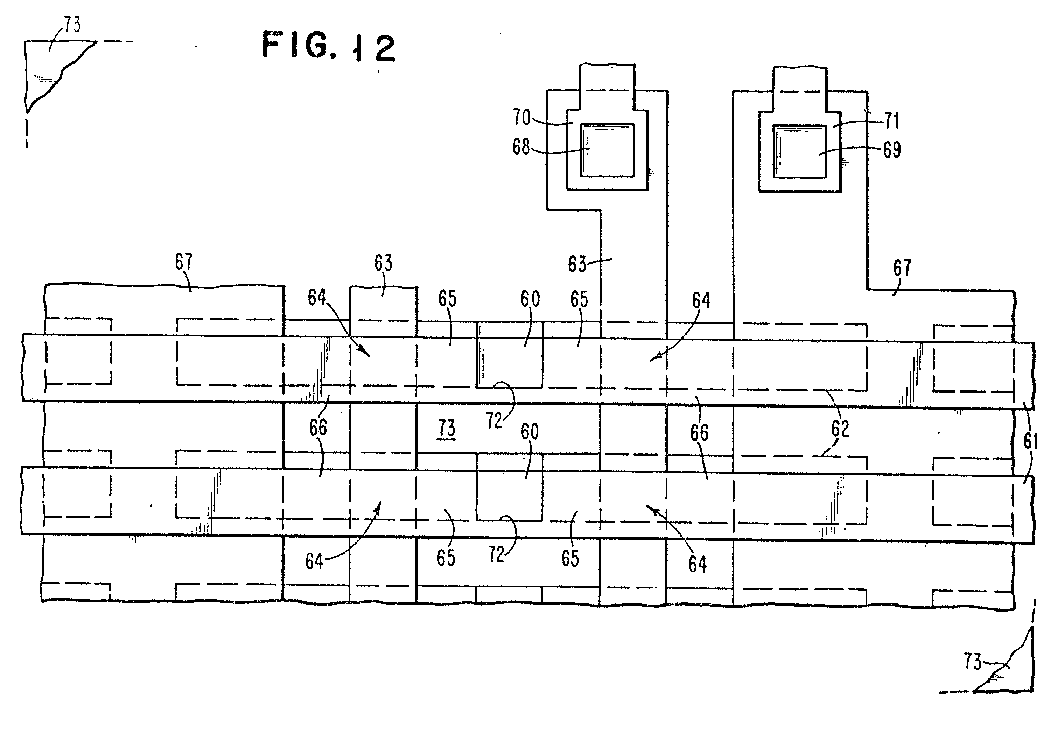

On se reportera à présent aux figures 11 et 12, qui représentent des vues de dessus de cellules à un seul dispositif, constituant une mémoire à accès aléatoire (RAM) du type dynamique. Ces cellules sont réalisées, dans le cas de la figure 21, en utilisant des contacts entre conducteurs métalliques et régions dopées de type n, réalisés au moyen de trous de contact décapés de type classique, et, dans le cas de la figure 12, au moyen de trous de contact auto-alignés réalisés conformément au procédé de la présente invention. Les cellules représentées sur la figure 11 ont été utilisées dans des blocs de mémoire RAM dynamique de type commercial à 4 096 et 16 384 bits.

Une cellule à un seul dispositif se compose d'un transistor à effet de champ et d'un condensateur d'emmagasinage de charge. Les informations (c'est-à-dire la charge électronique emmagasinée dans le condensateur) peuvent être obtenues au moyen de deux lignes d'adressage perpendiculaires : une ligne de mot en polysilicium et une ligne de bit en métal. La ligne de bit en métal entre en contact avec les régions de source diffusées de type n des transistors à effet de champ de deux cellules adjacentes. Sur la figure 11, les trous de contact 60 assurent la connexion entre les lignes de bit métalliques 61 et les régions sous-jacentes dopées de type n 62. Les portes en polysilicium 63 qui sont les lignes de mot des cellules de mémoire de la figure 11 sont disposées sous la métallisation 61, au-dessus d'une région de canal 64 et entre les régions de source et de drain, 65 et 66, respectivement. Des plaques (ou électrodes) de condensateur en polysilicium 67, disposées de façon adjacente aux drains 66 et au-dessus du substrat semiconducteur complètent la structure des cellules de la mémoire. Le contact de porte 68 et le contact de plaque 69 à proximité immédiate de l'ensemble de cellules permettent d'établir des connexions électriques entre les métallisations 70 et 71, respectivement, et la porte en polysilicium 63 et la plaque en polysilicium 67, respectivement.

Pour une largeur de ligne donnée, il est souhaitable que la surface des cellules de la mémoire RAM soit la restreinte faible possible, de manière à pouvoir augmenter le nombre de cellules réalisées par blocs. Comme le montre la figure 11, la nécessité de prévoir autour du contact, entre le métal et la région diffusée à proximité des trous de contact 60, une région destinée à tenir compte des défauts d'alignement éventuels, a pour effet d'augmenter la surface de la cellule. La surface du contact est donc à son tour influencée par l'espacement S, qui est nécessaire pour tenir compte des défauts éventuels d'alignement, entre le bord du trou de contact 60 et le bord 72 de la région encastrée d'oxyde d'isolement 73.

Les cellules représentées sur la figure 12 utilisent les trous de contact auto-alignés de la présente invention et ont une surface inférieure de 25 % à celle des trous de contact de la figure 11 pour un même rapport capacité d'emmagasinage/capacité de la ligne de bit, en raison de la suppression des régions qui entouraient les contacts pour tenir compte d'éventuels défauts d'alignement. Les cellules de la figure 12 utilisent un contact entre le métal et le silicium de type n présentant une surface minimum définie par l'intersection d'une ligne en résine photo-sensible de largeur minimum et d'une région dopée de largeur mininum. La ligne en résine s'étend jusqu'à la région encastrée d'isolement en oxyde qui existe à chaque extrémité de la région dopée, donnant ainsi la région de contact rectangulaire représentée sur la figure 12.

Les éléments de la figure 12 qui sont identiques à ceux de la figure 11 portent les mêmes numéros de référence que ceux représentés sur cette dernière figure. Ainsi, la partie supérieure et la partie inférieure des trous de contact 60 sont auto-alignées par rapport aux bords de la région encastrée d'isolement en oxyde 73. La ligne de bit métallique 61 peut présenter un léger défaut d'alignement par rapport aux trous de contacts 60 sans que cela affecte les avantages de la présente invention. En fait, il n'y a plus lieu de prévoir l'espacement S (voir figure 11) entre les bords 72 des régions encastrées 73 dans les cellules parce que les bords supérieur et inférieur des trous de contact 60 sont auto-alignés par rapport aux régions encastrées 73, comme le montre la figure 12. De ce fait, l'espacement entre les cellules de mémoire de la figure 12 peut être réduit au minimum puisqu'il n'y a pas lieu de prévoir de régions destinées à assurer l'établissement de contacts entre les trous de contact 60 qui sont décapés comme dans le cas de la figure 11 et les régions dopées sous-jacentes 62. Il ressort clairement d'une comparaison des figures 11 et 12 que le fait de fournir des trous de contact auto-alignés, comme dans le cas de la figure 12, permet de diminuer la surface requise et, par conséquent, d'obtenir une plus grande densité de cellules de mémoire par bloc.

**Revendication**

Procédé de fabrication de transistors à effet de champ du type métal-oxyde-semiconducteur (MOS) à grille et trous de contact auto alignés caractérisé en ce qu'il comporte les étapes suivantes

a) élaboration d'un substrat semiconducteur d'un premier type de conductivité (P1),

b) formation d'une couche de barrière d'oxydation (40, 46, 47) sur le substrat selon une configuration délimitée (43),

c) oxydation des portions exposées du substrat à travers les ouvertures de la couche de barrière, pour former des premières régions d'isolement encastrées (18), épaisses (42) qui définissent une pluralité de régions semiconductrices isolées,

d) élimination de la couche de barrière selon une nouvelle configuration délimitée (44) ; de telle sorte que la partie restante de la couche de barrière soit adjacente auxdites premières régions et exposant une portion centrale du substrat,

e) formation d'une nouvelle mince couche d'oxyde de porte (48) sur les parties exposées du substrat,

f) dépôt sur cette mince couche isolante (48) dans sa partie centrale d'une électrode de porte en polysilicium dopé (50),

g) implantation d'ions d'impuretés d'un type opposé de conductivité dans le substrat pour former les régions source et drain (51, 52) d'un transistor à effet de champ et à porte isolée auto-alignée,

h) oxydation des portions exposées du substrat et de l'électrode de porte pour former les couches d'isolement (53) puis élimination des parties restantes de la couche de barrière d'oxydation qui forme des trous de contact auto-alignés (54) avec les régions de sources et de drain et formation d'un trou de contact (55) pour exposer la porte en polysilicium (50) et,

i) formation d'un réseau d'interconnexion de conducteurs selon une configuration désirée (56, 57) qui fournit les contacts électriques avec les régions source, drain et porte.

## Claim

A process for fabricating field effect transistors of the metal — oxide — semiconductor (MOS) type with self aligned contact vias and gates characterized in that it comprises the following steps :

a) providing a semi conductor substrate of a first type of conductivity (P1),

b) forming an oxidation barrier layer (40, 46, 47) over the substrate according to a delineated pattern (43),

c) oxiding the exposed portions of the substrate through the openings provided into the barrier layer to form first thick recessed isolation region (18, 42) defining a plurality of isolated semi conducting regions,

d) removing the barrier layer according to a new delineated pattern (44) so that the remaining portion of the barrier layer is adjacent to said first regions and to expose a central portion of the substrate,

e) forming a new thin layer of gate oxide (48) over the exposed portions of the substrate,

f) applying a doped polysilicon gate electrode (50) over the central portion of said thin isolating layer (48),

g) implanting impurity ions of an opposite type of conductivity into the substrate fo form source and drain regions (51, 52) of a field effect transistor with a self-aligned isolated gate,

h) oxidizing the exposed portions of the substrate and the gate electrode to form isolating layers (53) then removing the remaining portions of the oxidation barrier layer which form contact vias (54) self-aligned with the source and drain regions and forming a contact via (55) to expose polysilicon gate (50) and,

i) forming a conductor interconnecting network according to a desired pattern (56, 57) which provides the electrical contacts with the source, drain and gate regions.

## Patentanspruch

Verfahren zur Herstellung von Feldeffekt-Transistoren vom Metall-Oxid-Silizium-Typ (MOS) mit selbstjustiertem Gate und selbstjustierten Kontaktloechern, dadurch gekennzeichnet, dass es folgende Schritte aufweist :

a) Herstellung eines Halbleitersubstrats eines ersten Typs von Leitfaehigkeit (P1),

b) Bildung einer Oxidation-Sperrschicht (40, 46, 47) auf dem Substrat einem begrenzten Muster entsprechend (43),

c) Oxidation der durch die Oeffnungen der Sperrschicht freigelegten Teile des Substrats zur Bildung von ersten eingebetteten isolierten (18), dicken (42), Bereichen, die eine Mehrzahl von isolierten halbleitenden Bereichen definieren,

d) Entfernung der Sperrschicht einem neuen begrenzten Muster (44) entsprechend, so dass der uebrige Teil der Sperrschicht den ersten Bereichen angrenzend liegt und ein mitten auf dem Substrat befindlicher Teil freigelegt ist,

e) Bildung einer neuen duennen Gate-Oxidschicht (48) auf den freigelegten Teilen des Substrats,

f) Aufbringen einer aus dopiertem Polysilizium (50) bestehenden Gate-Elektrode in der Mitte dieser duennen Isolierungsschicht (48),

g) Einbau von aus Stoerstellen eines entgegengesetzten Typs von Leiffaehigkeit bestehenden Ionen zur Bildung von den Source- und Drain- Bereichen (51, 52) eines Feldeffekt-Transistors mit einem isolierten selbstjustierenden Gate,

h) Oxidation der freigelegten Bereichen des Substrats und der Gate-Elektrode zur Bildung von Isolierungsbereichen (53) und anschliessend Entfernung der uebrigbleibenden Sperrschicht-Teile, die sebstjustierende Kontaktloechern (54) bilden, und Bildung eines Kontaktloches (55) zum Freilegen des Polysilizium-Gate (50), und i) Bildung eines Netzes fuer die Verbindung von Leitern einem erwuenschten Muster entsprechend (56, 57), das die elektrischen Anschluesse mit den Source-, Drain-, und Gate-Bereichen versorgt.

# FIG. 1

42
41
P2
43
47
40
46
42
41
P2
P1

# FIG. 2

44
43
46
47
40 46
44
42
41
P2
42
41
P2
P1

# FIG. 3

47 40
50
48
47 40
42
41
P2
42
41
P2
P1
49
49

# FIG. 4

54
53
55
53
54
50
48
42
41
P2
N
N
42
41
P2
P1
51
52

# FIG. 5

56
54
57
53
54
56
53
50 48
42
41
P2
N
N
42
41
P2
P1
49
51
52
49

FIG. 6

FIG. 7

FIG. 8

FIG. 9

FIG. 10

FIG. 11

FIG. 12

0 007 005